# EUROPEAN PATENT SPECIFICATION

(11) **EP 4 113 599 B1**
(45) Date of publication and mention of the grant of the patent: **18.11.2026**
(21) Application number: 22181152.4
(22) Date of filing: 27.06.2022
(51) Int. Cl.: H10W 70/40

(54) **METHOD OF MANUFACTURING SEMICONDUCTOR DEVICES, CORRESPONDING SUBSTRATE AND SEMICONDUCTOR DEVICE**
VERFAHREN ZUM HERSTELLEN VON HALBLEITERVORRICHTUNGEN, ENTSPRECHENDES SUBSTRAT UND HALBLEITERVORRICHTUNG
PROCÉDÉ DE FABRICATION DE DISPOSITIFS SEMICONDUCTEURS, SUBSTRAT CORRESPONDANT ET DISPOSITIF SEMICONDUCTEUR

(30) Priority: 30.06.2021 IT 202100017189
(43) Date of publication of application: 04.01.2023
(73) Proprietor: STMicroelectronics S.r.l., 20864 Agrate Brianza (MB) (IT)
(72) Inventor: MAZZOLA, Mauro, 24040 Calvenzano (Bergamo) (IT)
(74) Representative: Buzzi, Notaro & Antonielli d'Oulx S.p.A.

(56) References cited:
- US-A1- 2020 035 586

## Description

### Technical field

The description relates to semiconductor devices.

One or more embodiments may be applied, for instance, to semiconductor devices including a pre-molded leadframe.

One or more embodiments may be applied to semiconductor devices of the Quad-Flat No-lead (QFN) type.

### Background

A current approach in manufacturing semiconductor devices such as, for instance, QFN package semiconductor devices, involves arranging (attaching) a plurality of semiconductor dice or chips onto a strip-like substrate such as a pre-molded leadframe.

Individual devices are formed in a final "singulation" step involving sawing the substrate having the semiconductor dice or chips arranged thereon and an insulating encapsulation molded thereon.

Mechanical load/vibrations produced during sawing can cause undesired delamination phenomena. Independently of or on top of that, thermal cycling (as deriving from assembly reflow or lifetime operation for power devices) can initiate delamination or make delamination worse, which may lead to in-field device failure.

Document US 2020/035586 A1, taken as a model for the preambles of claims 1, 6, and 9 discloses a chip-on-lead semiconductor device package including a leadframe having a plurality of signal leads. These signal leads include at least two signal leads each having a first face with a first surface area and, opposite the first face, a second face with a second surface area, the second faces of the at least two signal leads being exposed on a surface of the chip-on-lead device package. The signal leads can also include at least one signal lead having a first face with a third surface area and, opposite the first face of the at least one signal lead, a second face with the second surface area, the second face of the at least one signal lead being exposed on the surface of the chip-on-lead semiconductor device package.

The pads in such a device may exhibit a low resistance to delamination and may be unable to retain stable positions during sawing in the singulation step.

### Object and summary

An object of one or more embodiments is to contribute in overcoming the drawbacks outlined in the foregoing.

According to one of more embodiments, that object is be achieved by means of a method having the features set forth in claim 1 that follows.

One or more embodiments relate to corresponding component such as a pre-molded leadframe as per claim 6.

One or more embodiments relate to a corresponding semiconductor device as per claim 9. A QFN package may be exemplary of such a device.

One or more embodiments may provide a component in the form of a pre-molded leadframe for semiconductor devices where a modified half-etched layout of leads (pads) results in an anchoring shape for the leads which counters lead pull-out both in an "in-plane" and in a "vertical" direction.

One or more embodiments are compatible with the provision of wettable flanks for the leads.

One or more embodiments may contemplate shape modifications on the top side and the bottom side of electrically conductive pads such as leads.

In one or more embodiments, during leadframe formation (by etching, for instance) pad size is reduced on the top side in proximity of the package borderline with the bottom side exhibiting an area increased in size.

During pre-molding of the etched leadframe, pre-molding material (resin) fills open volumes thus created adjacent the pads. These volumes filled by pre-molding resin provide, once the resin is solidified, pillar structures which increase the resistance of pads to detachment by countering movement in the longitudinal direction, for instance.

The pads thus exhibit increased resistance to delamination and retain stable positions during sawing in the singulation step.

The possibility is maintained of creating wettable flanks, with a second etching on the bottom side, for instance.

### Brief description of the annexed figures

One or more embodiments will now be described, by way of example only, with reference to the annexed figures, wherein:
Figures 1A and 1B are plan views at the front (top) and back (bottom) level, respectively, of a conventional pre-molded leadframe,
Figures 2A and 2B are a partial front view and a partial back view, respectively, of a leadframe modified according to embodiments of the present description prior to a singulation step,
Figure 3 is an enlarged partial view of the portion of Figure 2B indicated by arrow III,
Figure 4 is a shadow-line representation of pads according to embodiments of the present description prior to a singulation step,
Figures 5, 6 and 7 are cross-sectional views according to lines V-V, VI-VI, and VII-VII, respectively, in Figure 4,
Figure 8 is a shadow-line presentation of pads as per embodiments of the present description after a singulation step,
Figure 9 is a side elevational view along line IX of Figure 8,
Figure 10 is a plan view of a semiconductor device according to embodiments of the present description, and
Figure 11 is a view of the portion indicated by arrow XI in Figure 10 represented on an enlarged scale.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

Semiconductor devices may comprise one or more semiconductor chips or dice arranged (attached) on substrates such as leadframes.

Plastic packages are commonly used for semiconductor devices. Such packages may include a leadframe providing a base substrate comprising electrically conductive material such as copper, sized and shaped to accommodate semiconductor chips or dice and providing pad connections (leads) for these chips or dice.

The designation "leadframe" (or "lead frame") is currently used (see, for instance the USPC Consolidated Glossary of the United States Patent and Trademark Office) to indicate a metal frame which provides support for an integrated circuit chip or die as well as electrical leads to interconnect the integrated circuit in the die or chip to other electrical components or contacts.

Leadframes are conventionally created using technologies such as a photo-etching technology. With this technology, metal (e.g., copper) material in the form of a foil or tape is etched on the top and bottom sides to create various pads and leads.

These technologies can be applied to a Quad-Flat No-leads or QFN packages, where the designation "no-leads" denotes the fact that no leads are provided which protrude radially of the package.

So-called "pre-molded" leadframes are currently used which include electrically insulating resin such as epoxy resin, for instance, molded onto a sculptured (e.g., photo-etched) leadframe using a flat molding tool, for instance.

Spaces left in the etched metal material are filled by pre-molding resin and the resulting leadframe has a total thickness which is the same thickness of the original etched leadframe.

After pre-molding (with the molded resin solidified, via heat or UV curing, for instance), deflashing and smearing processes can be applied to provide clean top/bottom metal surfaces.

Wettable flanks can be provided, e.g., during a second etching step which can be applied to the pre-molded leadframe to generate dedicated etched areas.

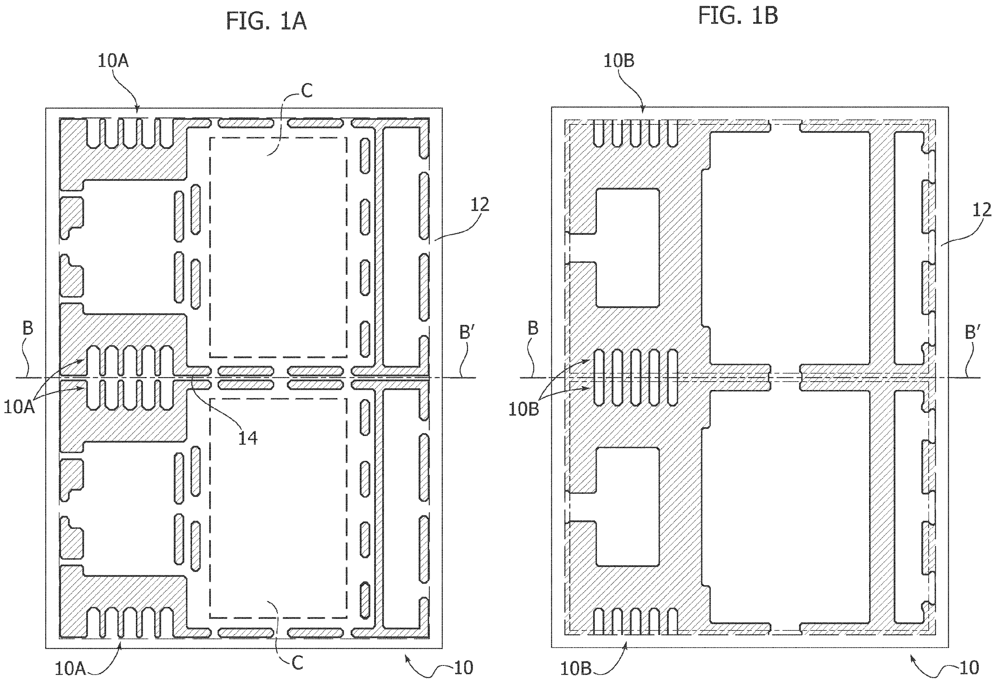

Figures 1A and 1B are plan views of the front (top) side and the back (bottom) side, respectively, of a portion of a pre-molded leadframe 10.

Figures 1A and 1B do indeed show two neighboring areas of a pre-molded leadframe 10 which are intended to be finally separated by sawing along a "singulation" line B-B' when forming individual semiconductor devices.

Current processes of manufacturing semiconductor devices involve processing simultaneously more than two such leadframe areas which are connected in a foil or strip and are intended to be finally "singulated" at plural cutting lines such as the line B-B'.

Two leadframe areas to be finally "singulated" by cutting at a single line B-B' are discussed here for simplicity.

Electrically-conductive pads (leads) are shown formed at the front or top side (as indicated by 10A) and the back or bottom side (as indicated by 10B) of the leadframe 10.

As illustrated, the pads designated 10A, 10B are at a peripheral location with respect to one or more die pads (only one is illustrated for simplicity) where a semiconductor chip or die C is intended to be arranged (attached) at the front or top side of the leadframe as shown in dashed lines for the two leadframe areas illustrated in Figure 1A.

In a pre-molded leadframe as illustrated in the figures the top-side pads 10A and the bottom-side pads 10B are arranged in pairs of opposed pads which are part of a same electrically conductive formation of the substrate (leadframe) 10. It is noted that such an arrangement, referred to for simplicity throughout this exemplary description, is not mandatory.

The leadframe areas illustrated in Figures 1A and 1B are thus exemplary of a mounting substrate 10 configured to have a plurality of semiconductor chips C arranged onto respective adjacent areas.

These (two or more) adjacent areas have mutually facing sides (see, for instance, the sides extending at the cutting line B-B' in Figures 1A and 1B) wherein the mounting substrate comprises a laminar, electrically conductive sculptured (e.g., etched) structure and electrically insulating material (an epoxy resin, for instance) 12 molded onto the sculptured structure.

The electrically conductive sculptured structure of the leadframe (comprising etched metal material such as copper, for instance) includes electrically conductive side formations of the adjacent areas of the leadframe so that adjacent areas of the leadframe (mounting substrate) have mutually facing electrically conductive side formations, namely the pads 10A, 10B.

Consequently, the electrically conductive side formations (the pads 10A, 10B) of one of the adjacent areas of the mounting substrate are arranged facing electrically conductive side formations (again, respective pads 10A, 10B) in another of the adjacent areas of the mounting substrate.

As visible in Figures 1A and 1B, the leadframe 10 (mounting substrate) has a front or top surface (Figure 1A) and a back or bottom surface (Figure 1B) and the electrically conductive side formations of the adjacent areas of the mounting substrate comprise first contact pads 10A and second contact pads 10B at the front surface and at the back surface, respectively, of the mounting substrate (leadframe) 10.

As discussed, the leadframe 10 is configured to be cut at mutually facing sides of the adjacent areas (along line B-B', for instance) and the mutually facing electrically conductive side formations, namely the pads 10A, 10B of adjacent areas of the mounting substrate are separated as a result of cutting.

As illustrated in Figures 1A and 1B, the side pads 10A at the front or top surface are wider and connected via a connecting bar 14 which is half-etched in the leadframe and intended to be removed as a result of cutting (e.g., along the line B-B') during a final singulation step to create individual semiconductor devices.

The side pads 10B on the back or bottom side are usually smaller, sized and dimensioned in view of mounting on a support substrate such a printed circuit board or PCB (not visible in the figures).

Pads such as those indicated at 10A and 10B in Figures 1A and 1B have a substantially rectangular shape with a (minimal) etching radius at the corners. It is noted that such a shape is not mandatory.

In packages where wettable flanks are provided, a second etching can be applied to the pre-molded leadframe to remove copper to a depth on the back or bottom side of the leadframe.

Unless indicated otherwise in the following, the foregoing is conventional in the art, which makes it unnecessary to provide a more detailed description herein.

As noted, after die attachment, wire bonding and package molding, the individual packages are separated in a singulation step using a disc sawing machine, for instance.

That is, the mounting substrate (leadframe 10) having a plurality of semiconductor chips C arranged thereon is cut at the mutually facing sides of the adjacent areas (e.g., along lines such as B-B') to provide individual singulated semiconductor devices.

In that way, the mutually facing, electrically conductive side formations (that is the pads 10A, 10B) of adjacent areas of the mounting substrate 10 are separated as a result of cutting (for instance, a disc blade cuts away the material between packages singulating the units of the final packages).

The electrically conductive sculptured structure of the leadframe 10 comprises connecting bars such as 14 between the contact pads 10A of adjacent areas of the leadframe at the front surface of the leadframe.

These connecting bars such as 14 are removed as a result of cutting the mounting substrate (leadframe) having a plurality of semiconductor chips C arranged thereon at the mutually facing sides of adjacent areas.

Again, such processing is conventional in the art.

A problem likely to arise during singulation is that stresses and vibrations resulting from cutting may adversely affect adhesion of the pads or leads to the resin (this applies both to the pre-molding resin of the leadframe here indicated at 12 and also to the final encapsulation molded onto the leadframe after attaching semiconductor chips thereon).

The pads (or leads: as used herein, the designation pads will cover both) should desirably stay in an exact position with respect to the package body over all the processing phases discussed in the foregoing, without undergoing detachment (so-called delamination) due to poor adhesion.

An approach proposed so far in order to address these issues includes increasing the roughness of the surfaces of the pads.

Applying oxided side walls during leadframe manufacturing on the lateral sides of the pads has also been experimented.

Both approaches were found to provide relatively small improvements in resistance to detachment, while undesirably adding to process time and cost.

One or more embodiments as discussed herein involve differentiating the shapes of contact pads such as 10A and 10B as provided on the front or top side and on the back or bottom side of the (pre-molded) leadframe 10.

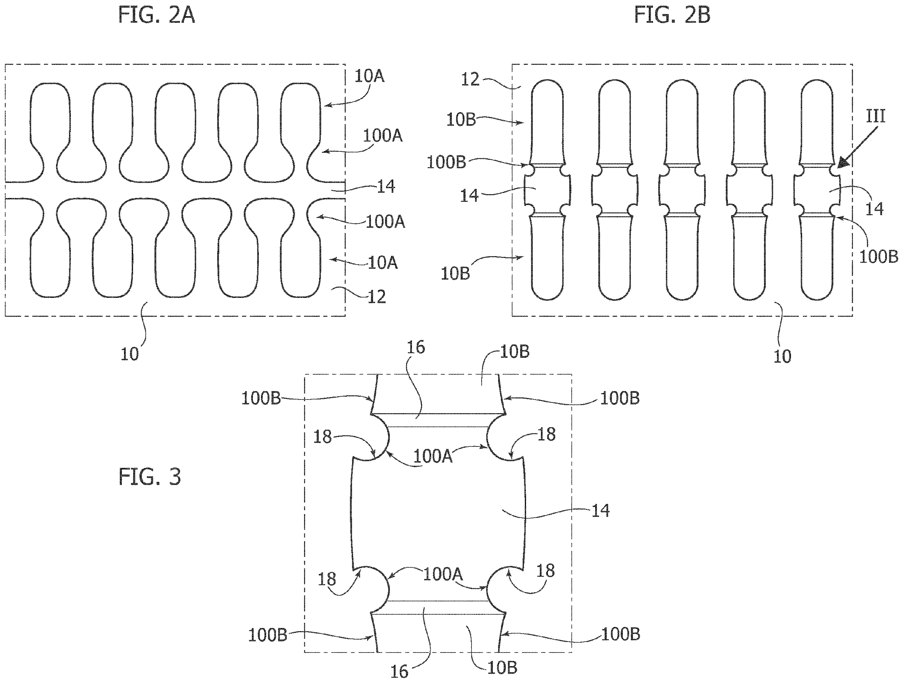

As exemplified in Figure 2A, the pads 10A at the front or top side of the leadframe 10 are formed - during etching, for instance - with narrowed portions 100A adjacent the connecting bar 14 (and thus adjacent the cutting line B-B') as illustrated in Figure 2A.

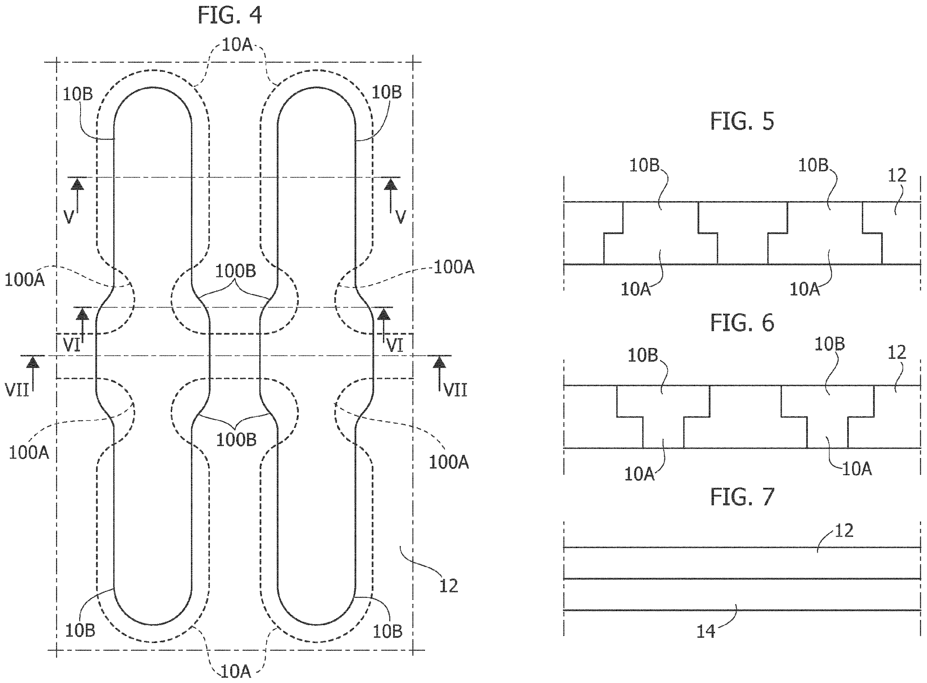

For instance, as illustrated in Figures 2A and 4, the contact pads 10A may be formed with a shape which can be approximately likened to an hourglass shape.

Conversely, as illustrated in Figures 2B and 4, for instance, the pads 10B at the back or bottom side are formed - again during etching, for instance - with (slightly) enlarged portions 100B adjacent the connecting bar 14.

For instance, as better appreciated in Figure 4, the contact pads 10B may be formed with a shape exhibiting an intermediate bulged portion, that is an intermediate swelling or protruding portion.

As noted, each pair of a front or top side pad 10A and a back or bottom side pad 10B as illustrated herein are assumed for simplicity to be part of a same electrically conductive formation as visible in the cross-sectional views of Figures 5 and 6**.**

These figures are cross sectional views along lines V-V and Vi-VI of Figure 4 which - like Figure 2B - is a plan view from the back or bottom side of the leadframe.

That is, in the cross-sectional views of Figures 5 and 6 the front or top pads 10A and the back or bottom pads 10B are illustrated facing downwards and upwards, respectively.

As illustrated herein, the electrically conductive formations comprising the pads 10A and 10B have a T-shaped (or mushroom-like) cross-section which:
in the body portions of the formations (away from the connection bar 12 and the cutting line B-B' - see Figure 5) is an inverted-T cross section with the pads 10A at the front or top surface (facing downwards in Figures 5 and 6) larger than the pads 10B at the back or bottom surface (facing upwards in Figures 5 and 6), and
in the portions located near the connection bar 12 and the cutting line B-B' - see Figure 6) is an upright-T cross section with the pads 10A at the front or top surface (facing downwards in Figures 5 and 6) narrower than the pads 10B at the back or bottom surface (facing upwards in Figures 5 and 6).

Figure 7 is a longitudinal cross-section along line VII-VII of Figure 4 through the connecting bar 14 which has a constant cross-section with a height approximately half the height or thickness of the leadframe 10: this may result from (further) etching of the leadframe metal material to create (in a manner known per se to those of skill in the art) wettable flanks 16 (see Figure 3) intended to facilitate soldering the final semiconductor packages on a support substrate such as a printed circuit board or PCB.

The shaping of the pads 10A, 10B exemplified in Figures 2A, 2B and 3 to 6 facilitates creating at the narrowed neck portions 100A of the pads 10A open volumes which are filled by the pre-molding resin 12 during leadframe pre-molding as visible from the back or bottom side as illustrated in Figures 2B and 3 (where the connecting bar 14 is clearly visible due to removal of material superposed thereto during the (further) etching step leading to the formation of the wettable flanks 16.

As a result, the pre-molding resin 12 penetrated (and solidified, via heat or UV curing, for instance) in these spaces forms "pillar" structures 18 which extend to a certain depth or height of the leadframe and provide a retaining "locking" structure of the pads 10A, 10B with respect to the pre-molding resin 12.

The solution described herein thus comprises shaping the electrically conductive side formations as represented by the pads 10A, 10B in adjacent areas of the mounting substrate to form the contact pads 10A at the front surface of the substrate 10 with (intermediate) narrowed portions 100A having side recesses, wherein the electrically insulating material 12 molded onto the sculptured structure of the leadframe 10 penetrates into these side recesses and creates (in response to being solidified, via heat or UV curing, for instance) formations, such as the "pillars" 18, for instance, that anchor the insulating material 12 to the electrically conductive sculptured structure of the mounting substrate represented by the leadframe 10.

The pillars 18 are beneficial in so far as they increase the resistance of the contact pads 10A, 10B to detachment (delamination), countering undesired movement of these pads 10A, 10B with respect to the pre-molding resin 12, primarily in the longitudinal direction of the pads 10A, 10B.

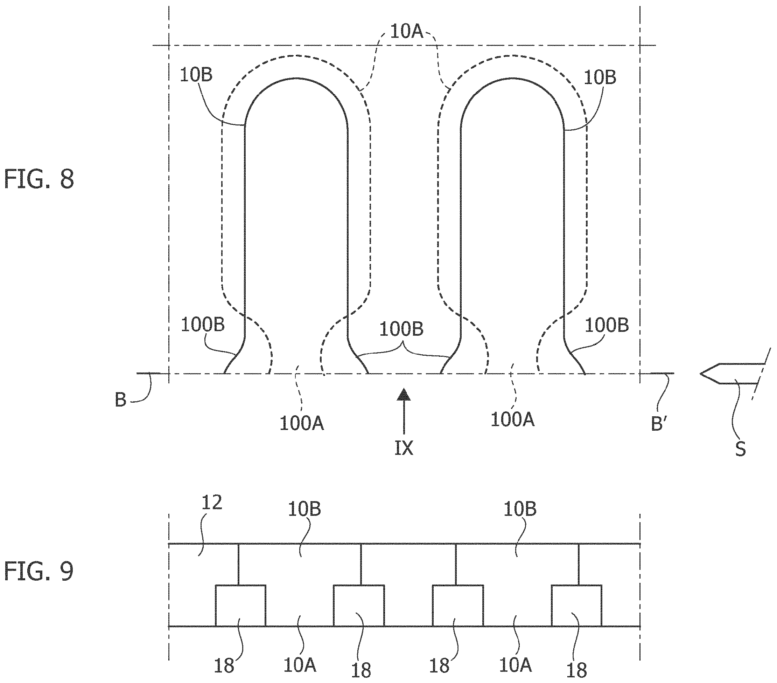

The pads 10A, 10B thus exhibit increased resistance to delamination and maintain stable positions as desired during the singulation cutting step along line B-B' as schematically represented by a blade S in Figure 8.

Advantageously, the contact pads 10B at the back surface of the leadframe 10 are provided with enlarged "bulging" (intermediate) portions 100B having side extensions adjacent the side recesses in the narrowed "necked" portions 100A the contact pads 10A at the front surface of the substrate.

This was found to create in the vicinity of the "pillars" 18 a shaped metal-resin interface beneficial in increasing resistance of pads 10A, 10B to detachment (delamination).

Solutions as described herein are compatible with conventional methods of manufacturing pre-molded leadframes, e.g.:
providing a laminar structure of an electrically conductive material such as copper, and
selectively removing electrically conductive material from the laminar structure to provide an electrically conductive sculptured structure with electrically conductive side formations such as 10A, 10B in adjacent areas of a mounting substrate (leadframe 10) having first 10A and second 10B contact pads at the front surface and the back surface, respectively.

Solutions as described herein are likewise compatible with conventional methods of providing so-called wettable flanks to facilitate soldering by, e.g., selectively removing electrically conductive material from the laminar structure of a leadframe at the electrically conductive side formations providing the pads 10A, 10B to provide wettable end flanks at the back surface of the substrate (leadframe) 10.

Selectively removing electrically conductive material from the laminar structure of the leadframe may be via selective etching as otherwise conventional in the art.

A substrate (leadframe) 10 as discussed herein can be produced by a supplier as a stand-alone product (component) and supplied to a manufacturer of semiconductor devices in view of manufacturing semiconductor devices with one or more semiconductor chips C mounted on such a mounting substrate comprising a laminar, electrically conductive sculptured structure and electrically insulating material 12 molded onto the sculptured structure of the substrate 10.

As can be appreciated, e.g**.,** from Figure 8, in the individual semiconductor devices resulting from singulation, the (first) contact pads 10A at the front surface of the substrate 10 will comprise narrowed (tapered) end portions 100A between side recesses.

The electrically insulating material 12 molded onto the sculptured structure of the leadframe 10 and thus penetrated into these side recesses provides (in response to being solidified, via heat or UV curing, for instance) anchoring formations 18 of the insulating material 12 to the electrically conductive sculptured structure of the substrate.

Advantageously, the anchoring effect can be further enhanced by the (second) contact pads 10B at the back surface of the substrate 10 comprising enlarged end portions 100B having side extensions adjacent the side recesses in the narrowed (tapered) end portions 100A of the contact pads 10A at the front surface of the substrate.

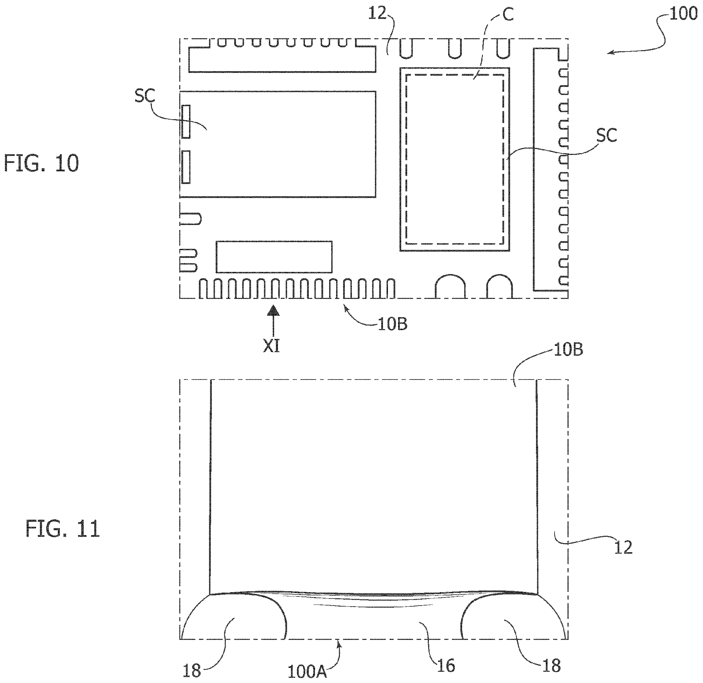

Figure 10 is an exemplary plan view (from the back or bottom surface) of a semiconductor device 100, such as a power QFN device for instance, which can be manufactured with the method discussed herein.

In Figure 10 (and Figure 11) the pads 10B at the back or bottom surface are visible with the resin 12 penetrating into the spaces or volumes formed at the narrowed (tapered) ends 100A of the pads 10A at the front or top surface to provide the pillar formations 18.

These formations safely retain the pads 10A, 10B in place while countering delamination from the premoulding resin 12.

Die mounting pads, designated SC, where one or more semiconductor chips or dice C are mounted (at the front or top portion of the leadframe - as indicated by dashed lines) are also visible in Figure 10.

The semiconductor device 100 illustrated in Figure 10 thus comprises one or more semiconductor chips C mounted on respective portions (see, e.g., the pads SC) of the front surface of a substrate 10.

The substrate has a back surface opposite the front surface and comprises a laminar, electrically conductive sculptured structure and electrically insulating material 12 molded onto the electrically conductive sculptured structure.

The electrically conductive sculptured structure comprises first 10A and second 10B contact pads at the front surface and the back surface of the substrate 10, respectively.

The first contact pads 10A at the front surface of the substrate have narrowed (tapered) end portions 100A (see Figure 8) having side recesses with the electrically insulating material 12 molded onto the electrically conductive sculptured structure of the substrate 10 penetrated into these side recesses.

As a result of being solidified the material 12 provides anchoring formations 18 to the electrically conductive sculptured structure of said mounting substrate 10.

Advantageously, the second contact pads 10B at the back surface of the substrate 10 have enlarged end portions 100B with side extensions adjacent the side recesses in the narrowed (tapered) end portions 100A of the first contact pads 10A at the front surface of the substrate.

Wettable flanks 16 of the second pads (10B) can be provided at the back surface of the mounting substrate 10 as illustrated in Figure 11.

Without prejudice to the underlying principles, the details and embodiments may vary, even significantly, with respect to what has been described by way of example only without departing from the extent of protection.

The extent of protection is defined by the annexed claims.

## Claims

1. A method, comprising:
arranging a plurality of semiconductor chips (C) onto respective adjacent areas of a mounting substrate (10), said adjacent areas having mutually facing sides (B-B'), wherein the mounting substrate comprises a laminar, electrically conductive sculptured structure and electrically insulating material (12) molded onto the electrically conductive sculptured structure, the electrically conductive sculptured structure comprising electrically conductive side formations (10A, 10B) of said adjacent areas of the mounting substrate, wherein adjacent areas of the mounting substrate have mutually facing electrically conductive side formations (10A, 10B) with electrically conductive side formations (10A, 10B) of one of said adjacent areas of the mounting substrate facing electrically conductive side formations (10A, 10B) in another of said adjacent areas of the mounting substrate, wherein the mounting substrate has a front surface and a back surface and said electrically conductive side formations of said adjacent areas of the mounting substrate comprise first (10A) and second (10B) contact pads at the front surface and the back surface, respectively, of the mounting substrate (10), and
cutting (S) the mounting substrate (10) having said plurality of semiconductor chips (C) arranged thereon at said mutually facing sides (B-B') of said adjacent areas to provide individual singulated semiconductor devices, wherein said mutually facing electrically conductive side formations (10A, 10B) of adjacent areas of the mounting substrate (10) are separated as a result of said cutting, and
shaping said electrically conductive side formations (10A, 10B) in adjacent areas of the mounting substrate (10) to form said first contact pads (10A) at the front surface of the mounting substrate with narrowed portions (100A) having side recesses at said mutually facing sides (B-B'), wherein the electrically insulating material (12) molded onto the electrically conductive sculptured structure of the mounting substrate (10) penetrates into said side recesses providing anchoring formations (18) of the insulating material (12) to the electrically conductive sculptured structure of said mounting substrate (10), **characterized in that** the method comprises shaping said electrically conductive side formations (10A, 10B) in adjacent areas of the mounting substrate to form said second contact pads (10B) at the back surface of the substrate with enlarged portions (100B) having side extensions at said mutually facing sides (B-B') adjacent said side recesses (16) in the narrowed portions (100A) of said first contact pads (10A) at the front surface of the substrate (10).

2. The method of claim 1, wherein the electrically conductive sculptured structure of the mounting substrate (10) comprises connecting bars (14) extending between first contact pads (10A) at the front surface of the mounting substrate of said mutually facing electrically conductive side formations (10A, 10B) of adjacent areas of the mounting substrate at said mutually facing sides (B-B') of said adjacent areas, wherein said connecting bars (14) are removed as a result of said cutting (S) the mounting substrate having said plurality of semiconductor chips (C) arranged thereon at said mutually facing sides (B-B') of said adjacent areas.

3. The method of any of the previous claims, comprising:
providing a laminar structure of an electrically conductive material, and
selectively removing electrically conductive material from said laminar structure to provide said electrically conductive sculptured structure with said electrically conductive side formations (10A, 10B) of said adjacent areas of the mounting substrate having said first (10A) and second (10B) contact pads at the front surface and the back surface, respectively, of the mounting substrate.

4. The method of claim 3, wherein selectively removing electrically conductive material from said laminar structure comprises selectively removing electrically conductive material from said laminar structure at said electrically conductive side formations (10A, 10B) to provide wettable flanks (16) of said second (10B) contact pads at the back surface of the mounting substrate (10).

5. The method of claim 3 or claim 4, comprising selectively removing electrically conductive material from said laminar structure via selective etching.

6. A substrate (10) configured to have a plurality of semiconductor chips (C) arranged onto respective adjacent areas thereof, said adjacent areas having mutually facing sides (B-B'), wherein the substrate is a mounting substrate and comprises a laminar, electrically conductive sculptured structure and electrically insulating material (12) molded onto the electrically conductive sculptured structure, the electrically conductive sculptured structure comprising electrically conductive side formations (10A, 10B) of said adjacent areas of the mounting substrate, wherein adjacent areas of the mounting substrate have mutually facing electrically conductive side formations (10A, 10B) with electrically conductive side formations (10A, 10B) of one of said adjacent areas of the mounting substrate facing electrically conductive side formations (10A, 10B) in another of said adjacent areas of the mounting substrate, wherein the mounting substrate has a front surface and a back surface and said electrically conductive side formations of said adjacent areas of the mounting substrate comprise first (10A) and second (10B) contact pads at the front surface and the back surface, respectively, of the mounting substrate (10),
wherein the mounting substrate (10) having said plurality of semiconductor chips (C) arranged thereon is configured to be cut (S) at said mutually facing sides (B-B') of said adjacent areas to provide individual singulated semiconductor devices, wherein said mutually facing electrically conductive side formations (10A, 10B) of adjacent areas of the mounting substrate (10) are separated as a result of said cutting, and
wherein said electrically conductive side formations (10A, 10B) in adjacent areas of the mounting substrate (10) comprise said first contact pads (10A) at the front surface of the mounting substrate (10) having narrowed portions (100A) with side recesses at said mutually facing sides (B-B'), with the electrically insulating material (12) molded onto the electrically conductive sculptured structure of the mounting substrate (10) penetrated into said side recesses providing anchoring formations (18) of the insulating material (12) to the electrically conductive sculptured structure of said mounting substrate (10),
**characterized in that** the mounting substrate (10) comprises said second contact pads (10B) at the back surface of the mounting substrate having enlarged portions (100B) having side extensions at said mutually facing sides (B-B') adjacent said side recesses (16) in the narrowed portions (100A) of said first contact pads (10A) at the front surface of the mounting substrate.

7. The substrate of claim 6, wherein the electrically conductive sculptured structure of the mounting substrate (10) comprises connecting bars (14) between the first contact pads (10A) at the front surface of the mounting substrate of said mutually facing electrically conductive side formations (10A, 10B) of adjacent areas of the mounting substrate, wherein said connecting bars (14) are configured to be removed as a result of said cutting (S) the mounting substrate having said plurality of semiconductor chips (C) arranged thereon at said mutually facing sides (B-B') of said adjacent areas.

8. The substrate (10) of any of claims 6 to 7, comprising wettable flanks (16) of said second (10B) contact pads at the back surface of the mounting substrate.

9. A semiconductor device (100) comprising:
at least one semiconductor chip (C) mounted on a front surface of a mounting substrate (10), the mounting substrate having a back surface opposite the front surface and comprising a laminar, electrically conductive sculptured structure and electrically insulating material (12) molded onto the electrically conductive sculptured structure, the electrically conductive sculptured structure comprising first (10A) and second (10B) contact pads at the front surface and the back surface of the mounting substrate (10), respectively, and
wherein said first contact pads (10A) at the front surface of the mounting substrate have narrowed end portions (100A) having side recesses with the electrically insulating material (12) molded onto the electrically conductive sculptured structure of the mounting substrate (10) penetrated into said side recesses and providing anchoring formations (18) of the insulating material (12) to the electrically conductive sculptured structure of said mounting substrate (10),
**characterized in that** the semiconductor device (100) comprises said second contact pads (10B) at the back surface of the mounting substrate having enlarged end portions (100B) with side extensions adjacent said side recesses in the narrowed end portions (100A) of said first contact pads (10A) at the front surface of the mounting substrate (10).

10. The semiconductor device (100) of claim 9, comprising wettable flanks (16) of said second (10B) contact pads at the back surface of the mounting substrate (10).

## Patentansprüche

1. Verfahren, umfassend:
Anordnen einer Vielzahl von Halbleiterchips (C) auf jeweils benachbarten Bereichen eines Montagesubstrats (10), wobei die benachbarten Bereiche einander gegenüberliegende Seiten (B-B') aufweisen, wobei das Montagesubstrat eine laminare, elektrisch leitfähige skulpturierte Struktur und elektrisch isolierendes Material (12) umfasst, das auf die elektrisch leitfähige skulpturierte Struktur geformt ist, wobei die elektrisch leitfähige skulpturierte Struktur elektrisch leitfähige Seitenformationen (10A, 10B) der benachbarten Bereiche des Montagesubstrats umfasst, wobei benachbarte Bereiche des Montagesubstrats einander gegenüberliegende elektrisch leitfähige Seitenformationen (10A, 10B) aufweisen, wobei die elektrisch leitfähigen Seitenformationen (10A, 10B) eines der benachbarten Bereiche des Montagesubstrats den elektrisch leitfähigen Seitenformationen (10A, 10B) in einem anderen der benachbarten Bereiche des Montagesubstrats zugewandt sind, wobei das Montagesubstrat eine Vorderseite und eine Rückseite aufweist und die elektrisch leitfähigen Seitenformationen der benachbarten Bereiche des Montagesubstrats erste (10A) und zweite (10B) Kontaktpads an der Vorderseite bzw. der Rückseite des Montagesubstrats (10) umfassen, und
Schneiden (S) des Montagesubstrats (10), auf dem die Vielzahl von Halbleiterchips (C) auf den einander gegenüberliegenden Seiten (B-B') der benachbarten Bereiche angeordnet sind, um einzeln getrennte Halbleitervorrichtungen bereitzustellen, wobei die einander gegenüberliegenden elektrisch leitfähigen Seitenformationen (10A, 10B) der benachbarten Bereiche des Montagesubstrats (10) infolge des Schneidens getrennt sind, und
Formen der elektrisch leitfähigen Seitenformationen (10A, 10B) in benachbarten Bereichen des Montagesubstrats (10), um die ersten Kontaktpads (10A) an der Vorderseite des Montagesubstrats mit verengten Abschnitten (100A) zu bilden, die seitliche Aussparungen an den einander gegenüberliegenden Seiten (B-B') aufweisen, wobei das elektrisch isolierende Material (12), das auf die elektrisch leitfähige skulpturierte Struktur des Montagesubstrats (10) geformt ist, in die seitlichen Aussparungen eindringt, wodurch der elektrisch leitfähigen skulpturierten Struktur des Montagesubstrats (10) Verankerungsformationen (18) des isolierenden Materials (12) bereitgestellt werden, **dadurch gekennzeichnet, dass** das Verfahren das Formen der elektrisch leitfähigen Seitenformationen (10A, 10B) in benachbarten Bereichen des Montagesubstrats umfasst, um die zweiten Kontaktpads (10B) an der Rückseite des Substrats mit vergrößerten Abschnitten (100B) zu bilden, die seitliche Verlängerungen an den einander gegenüberliegenden Seiten (B-B') aufweisen, die den seitlichen Aussparungen (16) in den verengten Abschnitten (100A) der ersten Kontaktpads (10A) an der Vorderseite des Substrats (10) benachbart sind.

2. Verfahren nach Anspruch 1, wobei die elektrisch leitfähige skulpturierte Struktur des Montagesubstrats (10) Verbindungsstäbe (14) umfasst, die sich zwischen den ersten Kontaktpads (10A) an der Vorderseite des Montagesubstrats der einander gegenüberliegenden elektrisch leitfähigen Seitenformationen (10A, 10B) benachbarter Bereiche des Montagesubstrats an den einander gegenüberliegenden Seiten (B-B') der benachbarten Bereiche erstrecken, wobei die Verbindungsstäbe (14) infolge des Schneidens (S) des Montagesubstrats entfernt werden, auf dem die Vielzahl von Halbleiterchips (C) an den einander gegenüberliegenden Seiten (B-B') der benachbarten Bereiche angeordnet sind.

3. Verfahren nach einem der vorstehenden Ansprüche, das Folgendes umfasst:
Bereitstellen einer laminaren Struktur aus einem elektrisch leitfähigen Material, und
selektives Entfernen von elektrisch leitfähigem Material aus der laminaren struktur, um die elektrisch leitfähige skulpturierte Struktur mit den elektrisch leitfähigen Seitenformationen (10A, 10B) der benachbarten Bereiche des Montagesubstrats bereitzustellen, wobei die ersten (10A) und zweiten (10B) Kontaktpads an der Vorderseite bzw. der Rückseite des Montagesubstrats vorhanden sind.

4. Verfahren nach Anspruch 3, wobei das selektive Entfernen von elektrisch leitfähigem Material aus der laminaren Struktur das selektive Entfernen von elektrisch leitfähigem Material aus der laminaren Struktur an den elektrisch leitfähigen Seitenformationen (10A, 10B) umfasst, um benetzbare Flanken (16) der zweiten (10B) Kontaktpads an der Rückseite des Montagesubstrats (10) bereitzustellen.

5. Verfahren nach Anspruch 3 oder Anspruch 4, umfassend das selektive Entfernen von elektrisch leitfähigem Material aus der laminaren Struktur durch selektives Ätzen.

6. Substrat (10), das so eingerichtet ist, dass es eine Vielzahl von Halbleiterchips (C) auf ihren jeweiligen benachbarten Bereichen aufweist, wobei die benachbarten Bereiche einander gegenüberliegende Seiten (B-B') aufweisen, wobei das Substrat ein Montagesubstrat ist und eine laminare, elektrisch leitfähige skulpturierte Struktur und ein elektrisch isolierendes Material (12), das auf die elektrisch leitfähige skulpturierte Struktur geformt ist, umfasst, wobei die elektrisch leitfähige skulpturierte Struktur elektrisch leitfähige Seitenformationen (10A, 10B) der benachbarten Bereiche des Montagesubstrats umfasst, wobei benachbarte Bereiche des Montagesubstrats einander gegenüberliegende elektrisch leitfähige Seitenformationen (10A, 10B) aufweisen, wobei die elektrisch leitfähigen Seitenformationen (10A, 10B) eines der benachbarten Bereiche des Montagesubstrats den elektrisch leitfähigen Seitenformationen (10A, 10B) in einem anderen der benachbarten Bereiche des Montagesubstrats zugewandt sind, wobei das Montagesubstrat eine Vorderseite und eine Rückseite aufweist und die elektrisch leitfähigen Seitenformationen der benachbarten Bereiche des Montagesubstrats erste (10A) und zweite (10B) Kontaktpads an der Vorderseite bzw. der Rückseite des Montagesubstrats (10) umfassen, wobei das Montagesubstrat (10) mit der darauf angeordneten Vielzahl von Halbleiterchips (C) so eingerichtet ist, dass es an den einander gegenüberliegenden Seiten (B-B') der benachbarten Bereiche geschnitten (S) werden kann, um einzeln getrennte Halbleitervorrichtungen bereitzustellen, wobei die einander gegenüberliegenden elektrisch leitfähigen Seitenformationen (10A, 10B) von benachbarten Bereichen des Montagesubstrats (10) infolge des Schneidens getrennt sind, und
wobei die elektrisch leitfähigen Seitenformationen (10A, 10B) in benachbarten Bereichen des Montagesubstrats (10) die ersten Kontaktpads (10A) an der Vorderseite des Montagesubstrats (10) umfassen, die verengte Abschnitte (100A) mit seitlichen Aussparungen an den einander gegenüberliegenden Seiten (B-B') aufweisen, wobei das elektrisch isolierende Material (12) auf die elektrisch leitfähige skulpturierte Struktur des Montagesubstrats (10) geformt ist und in die seitlichen Aussparungen eindringt, wodurch der elektrisch leitfähigen skulpturierten Struktur des Montagesubstrats (10) Verankerungsformationen (18) aus dem isolierenden Material (12) bereitgestellt werden,
**dadurch gekennzeichnet, dass** das Montagesubstrat (10) die zweiten Kontaktpads (10B) an der Rückseite des Montagesubstrats umfasst, die vergrößerte Abschnitte (100B) aufweisen, die seitliche Verlängerungen an den einander gegenüberliegenden Seiten (B-B') aufweisen, die den seitlichen Aussparungen (16) in den verengten Abschnitten (100A) der ersten Kontaktpads (10A) an der Vorderseite des Montagesubstrats benachbart sind.

7. Substrat nach Anspruch 6, wobei die elektrisch leitfähige skulpturierte Struktur des Montagesubstrats (10) Verbindungsstäbe (14) zwischen den ersten Kontaktpads (10A) an der Vorderseite des Montagesubstrats der einander gegenüberliegenden elektrisch leitfähigen Seitenformationen (10A, 10B) benachbarter Bereiche des Montagesubstrats umfasst, wobei die Verbindungsstäbe (14) so eingerichtet sind, dass sie infolge des Schneidens (S) des Montagesubstrats entfernt werden, auf dem die Vielzahl von Halbleiterchips (C) an den einander gegenüberliegenden Seiten (B-B') der benachbarten Bereiche angeordnet sind.

8. Substrat (10) nach einem der Ansprüche 6 bis 7, umfassend benetzbare Flanken (16) der zweiten (10B) Kontaktpads an der Rückseite des Montagesubstrats.

9. Halbleitervorrichtung (100), die Folgendes umfasst:
mindestens einen Halbleiterchip (C), der auf einer Vorderseite eines Montagesubstrats (10) montiert ist, wobei das Montagesubstrat eine der Vorderseite gegenüberliegende Rückseite aufweist und eine laminare, elektrisch leitfähige skulpturierte Struktur und ein elektrisch isolierendes Material (12), das auf die elektrisch leitfähige skulpturierte Struktur geformt ist, umfasst, wobei die elektrisch leitfähige skulpturierte Struktur erste (10A) und zweite (10B) Kontaktpads an der Vorderseite bzw. der Rückseite des Montagesubstrats (10) umfasst, und
wobei die ersten Kontaktpads (10A) an der Vorderseite des Montagesubstrats verengte Endabschnitte (100A) aufweisen, die seitliche Aussparungen mit dem elektrisch isolierenden Material (12) aufweisen, das auf die elektrisch leitfähige skulpturierte Struktur des Montagesubstrats (10) geformt und in die seitlichen Aussparungen eingedrungen ist, wodurch der elektrisch leitfähigen skulpturierten Struktur des Montagesubstrats (10) Verankerungsformationen (18) des isolierenden Materials (12) bereitgestellt werden,
**dadurch gekennzeichnet, dass** die Halbleitervorrichtung (100) die zweiten Kontaktpads (10B) an der Rückseite des Montagesubstrats umfasst, die vergrößerte Endabschnitte (100B) mit seitlichen Verlängerungen aufweisen, die den seitlichen
Aussparungen in den verengten Endabschnitten (100A) der ersten Kontaktpads (10A) an der Vorderseite des Montageesubstrats (10) benachbart sind.

10. Halbleitervorrichtung (100) nach Anspruch 9, umfassend benetzbare Flanken (16) der zweiten (10B) Kontaktpads an der Rückseite des Montagesubstrats (10).

## Revendications

1. Procédé comprenant les étapes suivantes :
disposer une pluralité de puces de semiconducteur (C) sur des zones adjacentes respectives d'un substrat de montage (10), lesdites zones adjacentes ayant des côtés mutuellement en regard (B-B'), dans lequel le substrat de montage comprend une structure sculptée laminaire et électriquement conductrice et un matériau électriquement isolant (12) moulé sur la structure sculptée électriquement conductrice, la structure sculptée électriquement conductrice comprenant des formations latérales électriquement conductrices (10A, 10B) desdites zones adjacentes du substrat de montage, dans lequel les zones adjacentes du substrat de montage comportent des formations latérales électriquement conductrices mutuellement en regard (10A, 10B) avec des formations latérales électriquement conductrices (10A, 10B) de l'une desdites zones adjacentes du substrat de montage en regard de formations latérales électriquement conductrices (10A, 10B) d'une autre desdites zones adjacentes du substrat de montage, dans lequel le substrat de montage a une surface avant et une surface arrière et lesdites formations latérales électriquement conductrices desdites zones adjacentes du substrat de montage comprennent des premières (10A) et deuxièmes (10B) plages de contact respectivement sur la surface avant et la surface arrière du substrat de montage (10), et
couper (S) le substrat de montage (10) sur lequel est disposée la pluralité de puces de semiconducteur (C) au niveau desdits côtés mutuellement en regard (B-B') desdites zones adjacentes pour fournir des dispositifs de semiconducteur singularisés individuels, dans lequel lesdites formations latérales électriquement conductrices mutuellement en regard (10A, 10B) de zones adjacentes du substrat de montage (10) sont séparées suite à ladite coupe, et
façonner lesdites formations latérales électriquement conductrices (10A, 10B) dans des zones adjacentes du substrat de montage (10) pour former lesdites premières plages de contact (10A) sur la surface avant du substrat de montage avec des parties étroites (100A) ayant des évidements latéraux au niveau desdits côtés mutuellement en regard (B-B'), dans lequel le matériau électriquement isolant (12) moulé sur la structure sculptée électriquement conductrice du substrat de montage (10) pénètre dans lesdits évidements latéraux fournissant des formations d'ancrage (18) du matériau isolant (12) à la structure sculptée électriquement conductrice dudit substrat de montage (10),
**caractérisé en ce que** le procédé comprend le fait de façonner lesdites formations latérales électriquement conductrices (10A, 10B) dans des zones adjacentes du substrat de montage pour former lesdites deuxièmes plages de contact (10B) sur la surface arrière du substrat avec des parties agrandies (100B) ayant des extensions latérales au niveau desdits côtés mutuellement en regard (B-B') adjacents auxdits évidements latéraux (16) dans les parties étroites (100A) desdites premières plages de contact (10A) sur la surface avant du substrat (10).

2. Procédé selon la revendication 1, dans lequel la structure sculptée électriquement conductrice du substrat de montage (10) comprend des barrettes de connexion (14) s'étendant entre les premières plages de contact (10A) sur la surface avant du substrat de montage desdites formations latérales électriquement conductrices mutuellement en regard (10A, 10B) de zones adjacentes du substrat de montage au niveau desdits côtés mutuellement en regard (B-B') desdites zones adjacentes, dans lequel lesdites barrettes de connexion (14) sont supprimées suite à ladite coupe (S) du substrat de montage sur lequel est disposée la pluralité de puces de semiconducteur (C) au niveau desdits côtés mutuellement en regard (B-B') desdites zones adjacentes.

3. Procédé selon l'une quelconque des revendications précédentes, comprenant les étapes suivantes :
fournir une structure laminaire d'un matériau électriquement conducteur, et
retirer sélectivement du matériau électriquement conducteur de ladite structure laminaire pour fournir ladite structure sculptée électriquement conductrice avec lesdites formations latérales électriquement conductrices (10A, 10B) desdites zones adjacentes du substrat de montage comportant lesdites premières (10A) et deuxièmes (10B) plages de contact respectivement sur la surface avant et la surface arrière du substrat de montage.

4. Procédé selon la revendication 3, dans lequel le retrait sélectif du matériau électriquement conducteur de ladite structure laminaire comprend le fait de retirer sélectivement du matériau électriquement conducteur de ladite structure laminaire au niveau desdites formations latérales électriquement conductrices (10A, 10B) pour fournir des flancs mouillables (16) desdites deuxièmes (10B) plages de contact sur la surface arrière du substrat de montage (10).

5. Procédé selon la revendication 3 ou 4, comprenant le fait de retirer sélectivement du matériau électriquement conducteur de ladite structure laminaire au moyen d'une gravure sélective.

6. Substrat (10) configuré pour avoir une pluralité de puces de semiconducteur (C) disposées sur des zones adjacentes respectives de celui-ci, lesdites zones adjacentes ayant des côtés mutuellement en regard (B-B'), dans lequel le substrat est un substrat de montage et comprend une structure sculptée laminaire et électriquement conductrice et un matériau électriquement isolant (12) moulé sur la structure sculptée électriquement conductrice, la structure sculptée électriquement conductrice comprenant des formations latérales électriquement conductrices (10A, 10B) desdites zones adjacentes du substrat de montage, dans lequel les zones adjacentes du substrat de montage comportent des formations latérales électriquement conductrices mutuellement en regard (10A, 10B) avec des formations latérales électriquement conductrices (10A, 10B) de l'une desdites zones adjacentes du substrat de montage en regard de formations latérales électriquement conductrices (10A, 10B) d'une autre desdites zones adjacentes du substrat de montage, dans lequel le substrat de montage a une surface avant et une surface arrière et lesdites formations latérales électriquement conductrices desdites zones adjacentes du substrat de montage comprennent des premières (10A) et deuxièmes (10B) plages de contact respectivement sur la surface avant et la surface arrière du substrat de montage (10),
dans lequel le substrat de montage (10) sur lequel est disposée ladite pluralité de puces de semiconducteur (C) est configuré pour être coupé (S) au niveau desdits côtés mutuellement en regard (B-B') desdites zones adjacentes pour fournir des dispositifs de semiconducteur singularisés individuels, dans lequel lesdites formations latérales électriquement conductrices mutuellement en regard (10A, 10B) de zones adjacentes du substrat de montage (10) sont séparées suite à ladite coupe, et
dans lequel lesdites formations latérales électriquement conductrices (10A, 10B) dans des zones adjacentes du substrat de montage (10) comprennent lesdites premières plages de contact (10A) sur la surface avant du substrat de montage (10) ayant des parties étroites (100A) avec des évidements latéraux au niveau desdits côtés mutuellement en regard (B-B'), dans lequel le matériau électriquement isolant (12) moulé sur la structure sculptée électriquement conductrice du substrat de montage (10) pénètre dans lesdits évidements latéraux fournissant des formations d'ancrage (18) du matériau isolant (12) à la structure sculptée électriquement conductrice dudit substrat de montage (10),
**caractérisé en ce que** le substrat de montage (10) comprend lesdites deuxièmes plages de contact (10B) sur la surface arrière du substrat de montage avec des parties agrandies (100B) ayant des extensions latérales au niveau desdits côtés mutuellement en regard (B-B') adjacents auxdits évidements latéraux (16) dans les parties étroites (100A) desdites premières plages de contact (10A) sur la surface avant du substrat de montage.

7. Substrat selon la revendication 6, dans lequel la structure sculptée électriquement conductrice du substrat de montage (10) comprend des barrettes de connexion (14) entre les premières plages de contact (10A) sur la surface avant du substrat de montage desdites formations latérales électriquement conductrices mutuellement en regard (10A, 10B) de zones adjacentes du substrat de montage, dans lequel lesdites barrettes de connexion (14) sont configurées pour être supprimées suite à ladite coupe (S) du substrat de montage sur lequel est disposée ladite pluralité de puces de semiconducteur (C) au niveau desdits côtés mutuellement en regard (B-B') desdites zones adjacentes.

8. Substrat (10) selon l'une quelconque des revendications 6 à 7, comprenant des flancs mouillables (16) desdites deuxièmes (10B) plages de contact sur la surface arrière du substrat de montage.

9. Dispositif de semiconducteur (100) comprenant :
au moins une puce de semiconducteur (C) montée sur une surface avant d'un substrat de montage (10), le substrat de montage ayant une surface arrière à l'opposé de la surface avant et comprenant une structure sculptée laminaire et électriquement conductrice et un matériau électriquement isolant (12) moulé sur la structure sculptée électriquement conductrice, la structure sculptée électriquement conductrice comprenant des premières (10A) et deuxièmes (10B) plages de contact respectivement sur la surface avant et la surface arrière du substrat de montage (10), et
dans lequel lesdites premières plages de contact (10A) sur la surface avant du substrat de montage ont des parties d'extrémité étroites (100A) ayant des évidements latéraux avec le matériau électriquement isolant (12) moulé sur la structure sculptée électriquement conductrice du substrat de montage (10) pénétrant dans lesdits évidements latéraux et fournissant des formations d'ancrage (18) du matériau isolant (12) à la structure sculptée électriquement conductrice dudit substrat de montage (10),
**caractérisé en ce que** le dispositif de semiconducteur (100) comprend lesdites deuxièmes plages de contact (10B) sur la surface arrière du substrat de montage ayant des parties d'extrémité agrandies (100B) avec des extensions latérales adjacentes auxdits évidements latéraux dans les parties d'extrémité étroites (100A) desdites premières plages de contact (10A) sur la surface avant du substrat de montage (10).

10. Dispositif de semiconducteur (100) selon la revendication 9, comprenant des flancs mouillables (16) desdites deuxièmes (10B) plages de contact sur la surface arrière du substrat de montage (10).
